# EUROPEAN PATENT APPLICATION

(11) **EP 0 590 706 A1**
(43) Date of publication of application: **06.04.1994**
(21) Application number: 93202592.7
(22) Date of filing: 06.09.1993
(51) Int. Cl.: H03G 3/34

(54) **Amplifier apparatus**

(30) Priority: 01.10.1992 US 954989
(71) Applicant: DELCO ELECTRONICS CORPORATION, Kokomo Indiana 46902 (US)
(72) Inventor: Jay, Ian Douglas, Logansport, Indiana 46947 (US); Buck, Paul Edward, Russiaville, Indiana 46979 (US)
(74) Representative: Denton, Michael John

(57) **Abstract**

An audio system normally maintains an audio input signal (10) coupled to an output (22) of the system, upon receipt of a mute command (18), the dynamic output of the system is reduced and thereafter a dummy input signal (12) is coupled to the system output (22) and the audio input signal (10) is decoupled from the system output (22) to provide a smooth transition from play mode to mute mode, minimising transient noise during the transition.

## Description

This invention relates to a method of controlling the operation of an amplifier system and to amplifier apparatus.

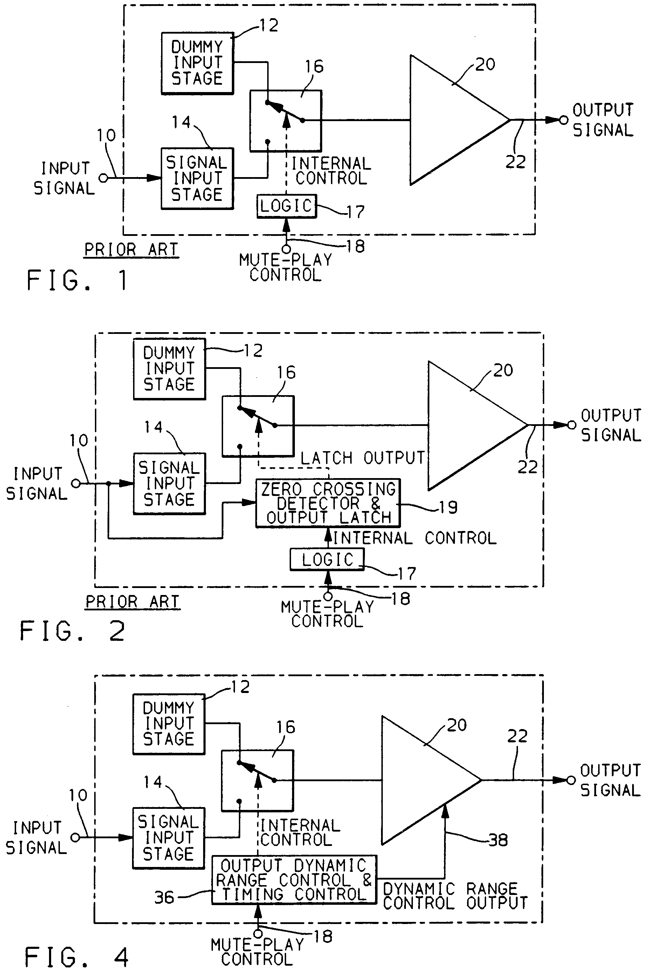

A typical audio system with a mute function is shown in Figure 1. In the system shown, muting is accomplished by switching the input of an output amplifier 20 between a signal input stage 14 and a dummy input stage 12. When the amplifier is in mute mode, dummy input stage 12 is enabled while signal input stage 14 is disabled so that no signals are passed to the output. When the amplifier is in play mode, signal input stage 14 is enabled while dummy input stage 12 is disabled and audio signals are passed to the output.

Transitions from mute mode to play mode and from play mode to mute mode are accomplished by switching switch circuit 16 between the two different input stages 12 and 14 in response to a command on line 18 coupled via logic circuitry 17. In amplifiers where there is no correlation between the instantaneous amplitude of the input signal and the mute-play transition command, the input signal can be at a non-zero level when a mute-to-play transition occurs. A non-zero input voltage at the point of transition gives rise to a "pop" at the output of the amplifier due to an abrupt change in the output voltage. When switching from mute mode to play mode at high input amplitudes, the "pop" is caused by a change from zero output to clipping as fast as the amplifier's slew rate allows. The same effect occurs during transition from play mode to mute mode.

The system shown in Figure 2 employs a zero crossing detector 19 to add a correlation between the instantaneous amplitude of the input signal and the moment of the mute-to-play transition. When zero crossing detector 19 detects that the instantaneous input signal is at a zero level, the mute-to-play transition can occur through operation of switch circuit 16. This reduces the "pop" in the output of the audio amplifier. However, since typical zero-crossing detectors detect when the input signal is in a range around zero, a "pop" still occurs in the output of the audio amplifier at a level defined by the detection window of the zero crossing detector.

The present invention seeks to provide an improved method of controlling the operation of an amplifier system and improved amplifier apparatus.

According to an aspect of the present invention, there is provided a method of controlling the operation of an amplifier system as specified in claim 1.

According to another aspect of the present invention, there is provided amplifier apparatus as specified in claim 5.

A muting function can be provided in an audio amplifier system through use of dynamic range reduction of the output amplifier of the audio system in which transient noise during switching can be substantially eliminated. Preferably, the need for zero crossing detection in the mute circuitry is eliminated.

In a preferred embodiment, when a signal for switching from play to mute is received, the dynamic range of the output amplifier is reduced from full dynamic range to a negligible dynamic range. The transition occurs over a brief, but non-zero time, providing a quick fade-out of the output signal. Immediately following the quick fade-out of the output signal, the input to the output amplifier is switched from the signal input stage to the dummy input stage, limiting the maximum change in the output signal which can occur during transition and effectively minimising transient noise associated with mute-to-play switching.

Preferably, when a signal is received for switching between mute mode and play mode, the dynamic range of the output amplifier is maintained at a minimum level. The input to the output amplifier is switched from the dummy input stage to the signal input stage. The dynamic range of the output amplifier is then ramped up from the negligible range to full range providing a quick fade-in of the output signal just after switching between the dummy input stage and the signal input stage.

In another embodiment, there is provided an audio amplifier comprising a dummy input stage, a signal input stage receiving an audio input signal, and a switch circuit with two inputs, one input coupled to the dummy input stage and one input coupled to the signal input stage. The switch circuit operatively switches between coupling the dummy input stage to a switch output and coupling the signal input stage to the switch output. An output amplifier including a dynamic range controller is coupled to the output of the switch circuit. A ramp and timing circuit ramps down the dynamic range control of the output amplifier in response to a mute command and then controls the switch circuit to couple the dummy input stage to the output amplifier and to isolate the signal input stage from the output amplifier.

An embodiment of the present invention is described below, by way of illustration only, with reference to the accompanying drawings, in which:
Figures 1 and 2 illustrate prior art audio amplifiers with muting functions;
Figure 3 is a flow chart of an embodiment of method of operating a mute facility;
Figure 4 is a schematic diagram of an embodiment of audio amplifier;
Figure 5 is a circuit diagram of the embodiment of control circuit for the apparatus of Figure 4;
Figures 6 and 7 are timing diagrams illustrating control signals for the circuit of Figure 5; and
Figure 8 illustrates various signals for the circuit of Figure 5.

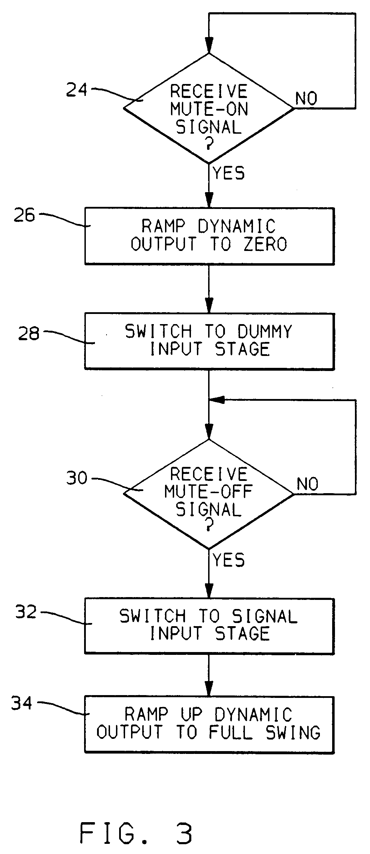

Referring to Figure 3, the embodiment of method of operating a mute facility in a radio includes the steps of waiting for a mute signal at step 24 and, upon receipt of the mute signal, adjusting in ramp manner the dynamic output of the output amplifier to a minimum amount or zero, at step 26. Step 28 switches the signal flow, isolating the signal input stage from the output amplifier and coupling the dummy input stage to the output amplifier, so as to feed the dummy input signal to the output amplifier to mute the system.

When the amplifier is in mute mode, the system waits for a play signal to turn off the mute mode at step 30. Once the play signal is received, indicating that the mute mode is to be turned off, step 32 switches the signal flow, isolating the dummy input stage from the output amplifier and coupling the input signal stage to the output amplifier, so as to feed the signal from the signal input stage to the output amplifier. After the signal from the input stage is coupled to the output amplifier, step 34 increases in ramp manner up to full amplitude the dynamic output of the output amplifier, resulting in a normal play mode for the system.

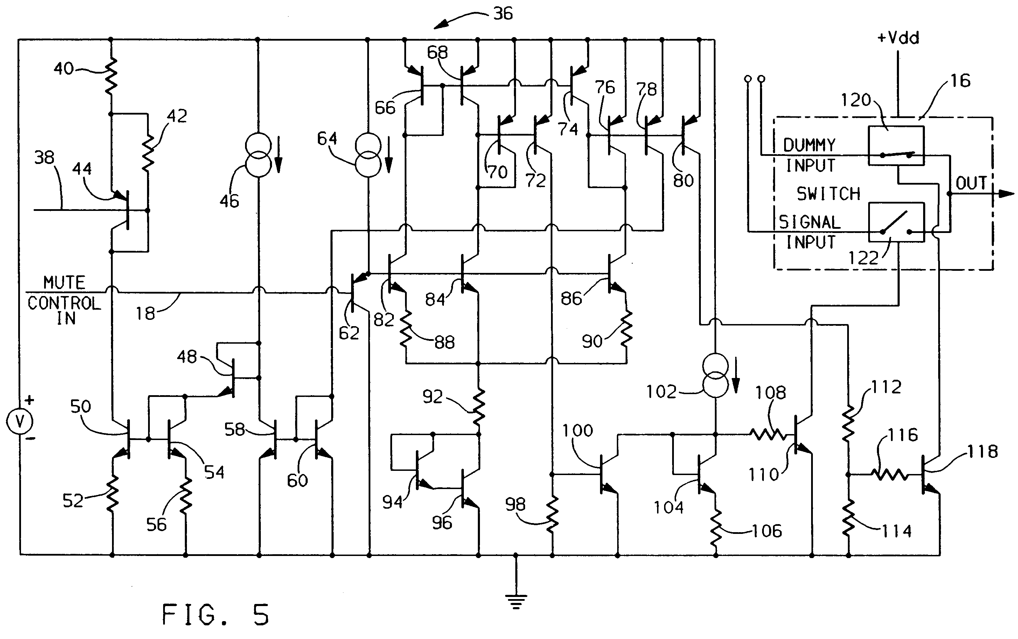

Referring to Figure 4, the embodiment of apparatus shown is coupled to an input signal on line 10, representative of any audio signal to be processed and to be output from the system on line 22. The signal on line 10 enters input signal stage 14, which is coupled to one input of switch circuit 16. The second input of switch circuit 16 is coupled to dummy stage 12, which outputs no audio signal and silences the system during the mute mode. Switch circuit 16 is controlled by control circuit 36, which controls switching of switch circuit 16 so that in a first mode the signal input stage is coupled to the output of switch circuit 16 and in a second mode the dummy input stage is coupled to the output of switch circuit 16.

Switch circuit 16 may comprise, for example, two transmission gates operating out of phase. In play mode, the first transmission gate couples input signal stage 14 to amplifier 20 while the second transmission gate isolates dummy input stage 12 from output amplifier 20. Conversely, in mute mode, the second transmission gate couples dummy input stage 12 to the output amplifier 20 while the first transmission gate isolates signal input stage 14 from output amplifier 20.

The control circuit 36 operates as follows. Line 18 is the mute/play control line and is controlled by the system controller (not shown), which is typically a microprocessor controller. Line 38 is a dynamic range control line for output amplifier 20. Many output amplifiers suitable for use as output amplifier 20 include a control node that, when biased to a predetermined level, limits the maximum dynamic range output of the output amplifier to that predetermined level. (For example, some existing amplifier circuits have a control node that reduces the swing of the output amplifier as an overheating temperature increases. If too high a temperature is reached, the output swing is reduced to zero.) Line 38 is coupled to the node controlling the dynamic range of the output of amplifier 20 and the signal level on line 38 controls the dynamic range of output amplifier 20.

When the system is in play mode, line 38 is set to maximise the normal play dynamic range level of output amplifier 20. For example, in a typical vehicle audio system, the audio signal has an AC ground at one half the supply voltage, that is around 7 volts, and has a maximum dynamic swing between zero and the supply voltage, that is 0 - 14 volts.

When a mute signal is received on line 18, control circuit 36 first reduces (ramps-down) the signal on line 38 to force an AC ground at the output of amplifier 20. As the signal on line 38 is reduced, the swing or dynamic range of the signal output from amplifier 20 is reduced, eventually virtually to zero.

After control circuit 36 reduces the signal on line 38, it outputs a switch control signal to switch circuit 16, which responsively de-couples signal input stage 14 from amplifier 20 and couples dummy input stage 12 to amplifier 20, providing a muted output on line 22. During the mute mode, control circuit 36 maintains the signal on line 38 to force the output of amplifier 20 to AC ground.

When it is desired to return from mute mode to play mode, control circuit 36, while maintaining the amplifier output at AC ground, controls switch circuit 16, de-coupling dummy input stage 12 from output amplifier 20 and coupling signal input stage 14 to output amplifier 20. Control circuit 36 then increases (ramps-up) the signal on line 38 to the maximum desired dynamic range setting for amplifier 20, providing an increase of the audio output signal on line 22 from mute to full play in a smooth transitional manner, virtually eliminating the possibility of "pops" or unpleasant sounds associated with the transition between mute and play modes of operation.

Control circuit 36 can be in the form of analogue circuitry, a combination of digital and analogue circuitry, or a combination of microprocessor control and analogue circuitry to perform the functions set forth below. For example, a microprocessor could be implemented to trigger a ramp-down circuit and then trigger switch circuit 16 to obtain mute mode, and conversely, trigger switch circuit 16 and then trigger a ramp-up circuit to return to play mode.

Referring to Figure 5, an embodiment of control circuit 36 is shown. In play mode, the signal on line 18 is held high maintaining transistor 62 in an off state. With transistor 62 off, current source 64 forward biases transistors 82, 84 and 86, which turn on current mirrors formed by transistors 66, 68 and 70 and 72. The current mirrors are driven from a current source formed by transistors 94 and 96 through resistors 88 and 92.

When transistor 72 turns on, transistor 100, normally held off by resistor 98, is forward biased, pulling low the base of transistor 110 via resistor 108, in which case current from current source 102 is diverted to ground. In this state, transistor 110 is off, maintaining transmission gate 122 on so that signal input stage 14 is coupled to output amplifier 20. (Transistor 104 and resistor 106 form biasing elements for the base of transistor 110.)

Likewise, transistor 86 turns on transistors 74, 76, 78 and 80, driven by the current source transistors 94 and 96 via resistors 90 and 92. Transistor 80 forward biases transistor 118 via resistors 112, 114 and 116. In this state, transistor 118 is on, maintaining transmission gate 120 off, which isolates the dummy input signal from output amplifier 20.

While transistor 78 is maintained on, it forward biases transistor 60, which mirrors current through transistor 58, which in turn draws all of the current from current source 46. With transistor 58 drawing the current from current source 46, transistor 48 is prevented from conducting, which maintains transistors 50 and 54 off. With transistors 50 and 54 off, transistor 44 is off and line 38, which controls output amplifier 20, is maintained at the supply voltage (14 volts) by pull up resistors 40 and 42.

When the mute control signal on line 18 goes low, transistor 62 conducts, turning off transistors 82, 84, 86 and transistors 66, 68, 70, 72, 74, 76, 78 and 80. As transistor 78 turns off, transistors 58 and 60 turn off and current source 46 begins driving transistor 48. Transistor 48 forward biases transistor 54 driving current through resistor 56, which current is mirrored in transistor 50 and through resistor 52. With transistor 50 conducting, transistor 44 switches from an off state to a forward biased state, reducing the signal on line 38 down from 14 volts to 7 volts and, in turn, limiting the dynamic swing of amplifier 20.

The voltage level of line 38 is a linear function of line 18. To provide reduction of the signal on line 18, a simple RC network (not shown) is coupled between the controller and line 18.

After the voltage on line 38 is reduced, transistor 100 shuts off, in which instance transistor 104 is forward biased maintaining a high voltage through resistor 108 to the base of transistor 110, which is now forward biased, switching off transmission gate 122, isolating input signal stage 14 from output amplifier 20. At almost the same time, transistor 118 becomes inactive, switching on transmission gate 120, coupling the dummy input stage 12 to output amplifier 20. The circuit is now in mute mode.

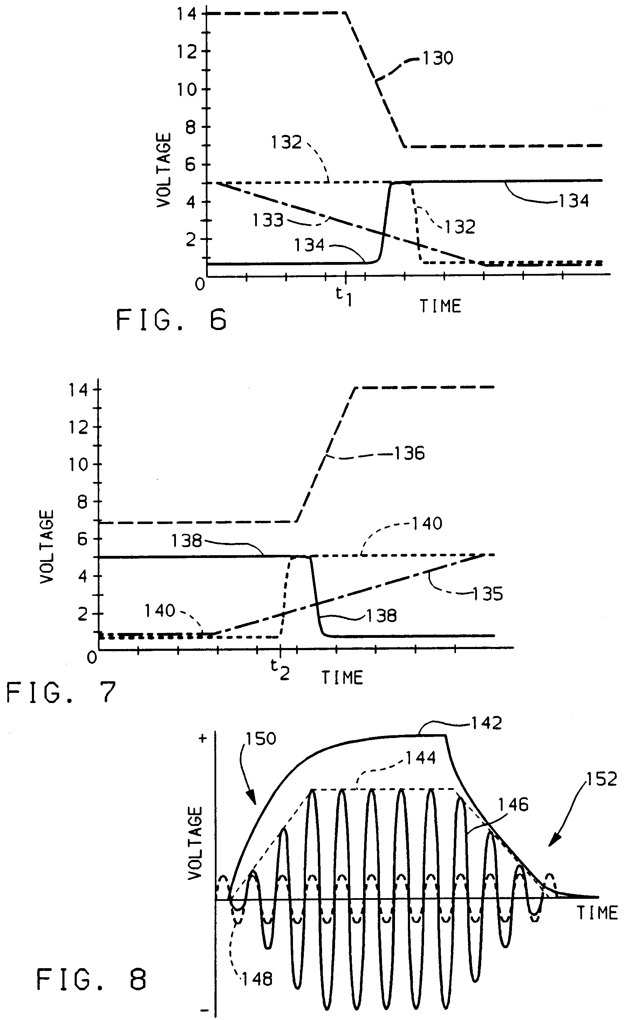

Figure 6 illustrates the signal on line 38 and the voltages across transistors 110 and 118 during the transition from play to mute mode. Line 130 illustrates that, at time t₁, the voltage on line 38 drops until it reaches AC ground. After the voltage on line 38 drops, the voltage across transistor 118, represented by line 134, goes from low to high turning on transmission gate 120, coupling dummy input stage 12 to output amplifier 20. Just after dummy input stage 12 is coupled to output amplifier 20, the voltage across transistor 110 goes from high to low, turning off transmission gate 122, decoupling signal input stage 14 from output amplifier 20. It is important that dummy stage 12 and signal input stage 14 are both coupled for a short time period during the transition to avoid noisy output transients from an open-loop amplifier circuit. Line 133 represents the input signal on line 18 and lines 130 and 133 together illustrate the linear relationship between the signal levels on lines 18 and 38 as line 18 is in the range between two and three volts.

When it is desired to return from mute mode to play mode, the control unit for the amplifier brings line 18 high, which turns off transistor 62 wherein current source 64 forces transistor 82 on. Transistors 94 and 96, via resistors 92, 88 and 90, draw current through transistors 82, 84 and 86 turning on the current mirror transistors 66, 68, 70, 72, 74, 76, 78 and 80. As transistor 80 turns on, transistor 118 becomes forward biased, turning off transmission gate 120 and decoupling dummy input stage 12 from output amplifier 20. As transistor 72 turns on, transistor 100 becomes forward biased forcing off transistor 110, turning on transmission gate 122 and coupling signal input stage 14 to output amplifier 20.

Next, as transistor 78 turns on, transistor 60 turns on, which mirrors current through transistor 58. Transistor 58 draws current from current source 46 away from transistor 48, such that transistors 50, 54 and 44 switch off. As transistor 44 shuts off, resistors 40 and 42 pull up line 38, as a linear function of the input signal on line 18. The voltage level on line 38 rises to the supply voltage (14 volts), bringing to full swing the dynamic range of output amplifier 20 and placing the system in play mode.

Figure 7 illustrates the signals at line 38 and across transistors 110 and 118 during the transition from mute mode to play mode. Line 140 illustrates the voltage across transistor 110, which goes high at time t₂, turning on transmission gate 122 and coupling signal input stage 14 to output amplifier 20. Line 138 illustrates the voltage across transistor 118, which goes low, turning off transmission gate 120 and decoupling dummy input stage 12 from output amplifier 20. Line 136 indicates the voltage on line 38, which then increases from AC ground at 7 volts to the full rail voltage at 14 volts providing a smooth transition between mute and play modes wherein the amplifier switches to full play mode. Line 135 represents the signal level on line 18.

Figure 8 illustrates signal levels for transitions from mute to play mode and from play to mute mode. Trace 142 represents the signal level on line 18, rising at portion 150 during a transition from mute to play mode and falling at portion 152 during a transition from play to mute mode. As the signal level 142 of line 18 rises, the envelope 144 indicating the dynamic output range of output amplifier 20 increases and the dynamic range of the output signal 146 of output amplifier 20 increases. Likewise, as the signal level 142 of line 18 decreases, the envelope 144 indicating the dynamic range output of output amplifier 20 decreases and the dynamic range of the signal 146 output from output amplifier 20 decreases. Signal 148 represents the audio input signal.

The above-described embodiment shows only one signal path through signal input stage 14 and amplifier 20. In stereophonic systems, two signal paths are provided for the two channels of audio information being processed. In such instances, there are two switch circuits 16, one for each channel of information, and two output amplifiers. The circuitry in Figure 5 need only be altered by adding transistors parallel to transistors 110 and 118 for controlling the second switch circuit, which would be coupled to a second dummy input stage and a second output amplifier. The second output amplifier would also have its dynamic range controlled by line 38.

Much of the circuitry shown in Figure 5 could be replaced by additional microcomputer controls, which would control timing of the signals, the dynamic output of the amplifier 20 and the switching between the input signals and dummy signals.

The disclosures in United States patent application no. 954,989, from which this application claims priority, and in the abstract accompanying this application are incorporated herein by reference.

## Claims

1. A method of controlling the operation of an amplifier system including a signal output stage, an output amplifier and a dummy input stage, the method comprising the steps of receiving a mute signal; upon receipt of the mute signal, reducing the dynamic output of the output amplifier; and after reduction of the dynamic output, coupling the dummy input stage to the output amplifier and decoupling the signal input stage from the output amplifier.

2. A method according to claim 1, comprising the steps of receiving a play signal; upon receipt of the play signal, coupling the signal input stage to the output amplifier and decoupling the dummy input stage from the output amplifier; and after coupling the signal input stage to the output amplifier, increasing the dynamic output of the output amplifier substantially up to a normal dynamic output.

3. A method according to claim 1 or 2, wherein the dynamic output of the output amplifier is decreased and/or increased substantially in ramp manner.

4. A method according to claim 1, 2 or 3, wherein for an audio amplifier system, the method comprises the step of maintaining an audio input signal coupled to the output amplifier until receipt of the mute command.

5. Amplifier apparatus comprising a signal input stage (10); a dummy input stage (12); a controllable switch circuit (16) including first and second inputs selectively couplable to an output, the first input being coupled to the dummy input stage and the second input being coupled to the signal input stage; an output amplifier (20), including a controllable dynamic range, coupled to the output of the switch circuit; and a control circuit (36) including receiving means (18) for receiving mute and play signals, adjusting means for reducing the dynamic range of the output amplifier upon receipt of a mute signal, a switch controller for controlling the switch circuit to couple the dummy input stage to the output amplifier and to decouple the signal input stage from the output amplifier after receipt of the mute signal and reduction of the dynamic range of the output amplifier.

6. Amplifier apparatus according to claim 5, wherein the switch controller is adapted to control the switch circuit upon receipt of a play signal to couple the signal input stage to the output amplifier and to decouple the dummy input stage from the output amplifier; the adjusting means being adapted to increase the dynamic range of the output amplifier upon receipt of a play signal and after coupling of the signal input stage to the output amplifier.

7. Amplifier apparatus according to claim 5 or claim 6, wherein the adjusting means is adapted to decrease and/or increase the dynamic range of the output amplifier substantially in ramp manner.
